# EUROPEAN PATENT APPLICATION

(11) **EP 0 549 995 A2**
(43) Date of publication of application: **07.07.1993**
(21) Application number: 92121778.2
(22) Date of filing: 22.12.1992
(51) Int. Cl.: H01L 21/302

(54) **Conditioning of semiconductor wafers for uniform and repeatable rapid thermal processing**

(30) Priority: 31.12.1991 US 815653
(71) Applicant: TEXAS INSTRUMENTS INCORPORATED, Dallas Texas 75265 (US)
(72) Inventor: MOSLEHI,Mehrdad M., Dallas,Texas 75248 (US)
(74) Representative: Schwepfinger, Karl-Heinz, Dipl.-Ing.

(57) **Abstract**

Several process flows are proposed for achieving suitable wafer backside conditions for a microfactory starting material. The backside conditions proposed here will be adapted for microfactory CMOS process flows based on multiple integrated rapid thermal processing (RTP) cycles. These backside conditions ensure repeatable RTP uniformity and easy pyrometry calibrations. The use of a highly doped layer near the wafer backside ensures zero infrared transmission and repeatable RTP-based process uniformity, particularly for the lower temperature RTP-based processes such as low pressure chemical vapor deposition silicon. Two backside layers are used (oxide and nitride) to prevent p+ outdiffusion and backside field oxide or gate growth. The backside condition disclosed prevent emissivity variations/drift during RTP.

## Description

### BACKGROUND OF THE INVENTION

Single-wafer rapid thermal processing (RTP) has become an important process for various applications such as thermal oxidation, epitaxial growth, junction annealing, silicide formation/anneal, CMOS (complementary metal oxide semiconductor) tank formation, and others. Major efforts have been focused on full-flow single-wafer integrated processing such as in microfactory and conventional factory environments. One important requirement in RTP is repeatable/precise temperature measurement and control. To eliminate the pattern and process effects on temperature measurement, one approach has been to perform multi-point wafer temperature measurement via light pipes inserted into a lamp assembly and looking at the wafer backside. Therefore, the condition of the wafer backside and any change in the backside conditions during RTP can have strong effects on temperature measurement accuracy and repeatability. Moreover, uniformity of the backside emissivity and uniform surface conditions can have a strong impact on the light pipe temperature measurement and therefore a strong impart on the RTP process uniformity and wafer-to-wafer repeatabilty. As a result, there is a need for pre-conditioning of the semiconductor wafer backsides to ensure repeatable and uniform backside emissivity with negligible drifts during the RTP process steps. Wafers having a single oxide layer on the wafer backside can be purchased from vendors. However, the single oxide layer only serves to prevent outdiffussion (and therefore furnace contamination) and does not address the other foregoing described needs of to produce uniform backside emissivity and surface conditions.

### BRIEF DESCRIPTION OF THE DRAWINGS

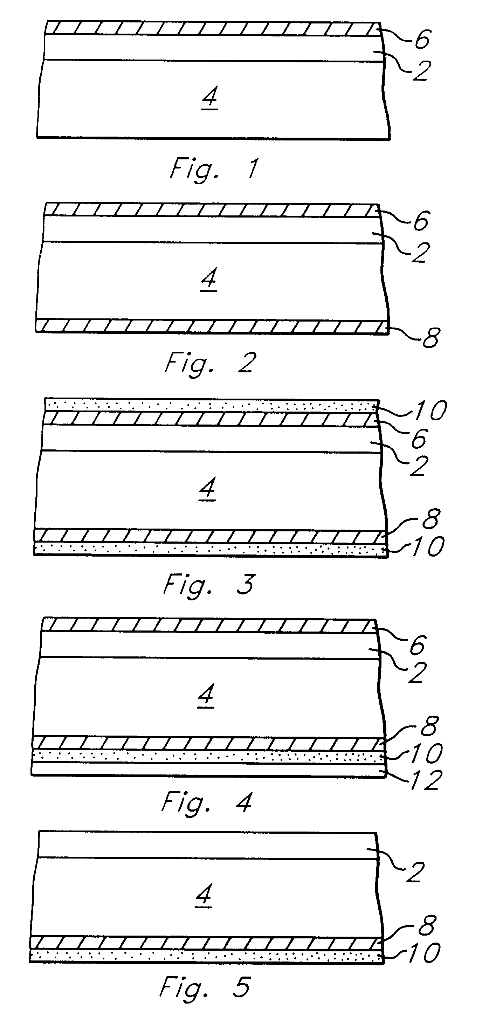

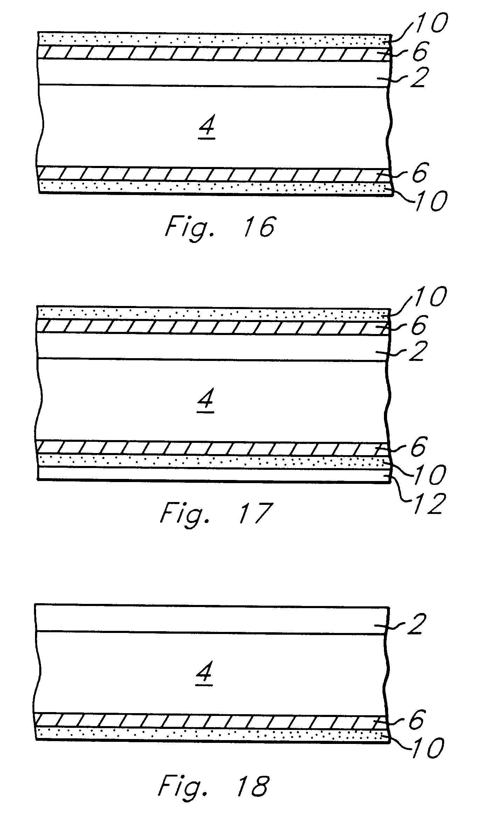

Figures 1 through 18 illustrate cross-sectional drawings of the structures produced from the invention's processing steps. Applicable reference numerals have been carried forward.

### DETAILED DESCRIPTION OF THE INVENTION

The following shall present process flows for pre-conditioning semiconductor wafer backsides for both epi-type wafers and bulk wafers.

Backside preparation for epitaxial wafers in similar to backside wafer preparation for bulk wafers with the most salient distinction being the lack of backside doping (by ion implantation or solid-source/ BSG) during epitaxial preparation as compared with bulk preparation.

The preferred process flow for conditioning the backside of an epitaxial wafer is as follows.
1) Starting with an epitaxial wafer, including lightly doped region 2 over highly doped region 4, as shown in cross-section in figure 1, protective oxide layer 6 is deposited on the of the wafer. This deposition may be accomplished by a method of single wafer plasma enhanced chemical vapor deposition (PECVD), resulting in a protective oxide layer thickness of between 500 to 1000Å
2) With reference to figure 2 which illustrates a cross-sectional drawing of the resulting structure, flip the wafer and deposit seal oxide 8 on the backside of the wafer via a single-wafer PECVD process. The resulting seal oxide is for instance, around 1000Å thick.
3) With reference to figure 3 which illustrates a cross-sectional drawing of the resulting structure, deposit silicon nitride layer 10 on the wafer front-side and backside using low pressure chemical vapor deposition, LPCVD.
4) As illustrated in figure 4 which shows a cross-section of the resulting structure from the following process step, coat the back side of the wafer with protective photoresist layer 12 and strip the front-side and backside nitride layers using a selective etch.
5) Strip the photoresist.
6) Strip the front-side oxide using a wet etch such as an HF etch. The resulting structure is illustrated in cross-section in figure 5.

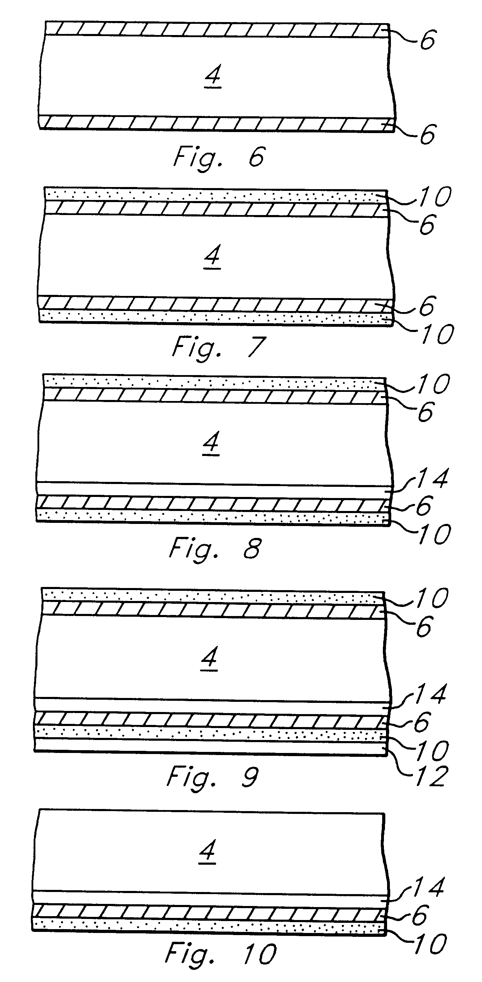

The following discloses a first preferred method of backside conditioning method which is applicable for bulk semiconductor wafers which are, for instance, lightly doped p (p-) or n (n-) type. This description is made with reference to figures 6 through 10 which illustrate cross-sectional drawings of the resulting structure from the following process steps.
1) Deposit a layer of silicon oxide 6 on both top and bottom of the wafer using a well known LPCVD process such as TEOS (tetra ethyl ortho silicate). Additionally, the oxide layer can be achieved using high pressure oxidation (HIPOX).
2) Deposit a layer of silicon nitride 10 by LPCVD on the front-side and backside of the wafer. The layer can be, for instance, 1300Å thick.
3) Perform a backside ion implantation of p-type material for a p- substrate or alternatively, perform a backside ion implantation of n-type material for a n-substrate. For instance, for a lightly doped p- substrate, the implant may comprise boron driven at 200-400 KeV at 1-2*10¹⁶ atoms per cm². A highly doped layer 14 is thus formed by the foregoing steps.
4) Coat the backside of the wafer with photoresist 12.
5) Etch away front-side nitride layer 10. This can be accomplished by well known plasma etch techniques.
6) Strip the front-side oxide layer 6 then strip photoresist 12.
7) Perform a pre-furnace clean of the wafer followed by an implant anneal.
8) The wafer is now prepared for integrated rapid thermal processing.
The backside p+/oxide/nitride layers are used for preventing infrared energy transmissions through the wafer. Pyrometry is sensitive to emissivity. Therefore the wafer is more opaque with a p+ or N+ layer near its back. Consequently, it is preferred the wafer backside is opaque. The p+/oxide/nitride additionally prevents p+ outdiffusion and cross-contamination effects of boron during thermal processing. Further, these layers prevent field oxide growth on the wafer backside. Note that the backside p+/oxide/nitride layers remain intact during the process flows all the way through back-end processing. The oxide/nitride layers on the backside can be removed before backside metallization. These conditions simplify temperature measurement and calibration during integrated single-wafer processing using RTP steps. The high temperature annealing required for introducing the highly concentrated dopant (i.e. boron) into the wafer backside (or forming the highly doped layer near the backside (i.e. a p+layer near the backside) can be combined with intrinsic gettering thermal cycles. This will eliminate the need for a separate thermal anneal step.

The following discloses a second preferred backside conditioning method which is applicable for bulk semiconductor wafers. This description is made with reference to figures 7 through 14 which illustrate cross-sectional drawings of the resulting structure from the following process steps.
1) Preclean wafer and follow the preclean with the formation of oxide 6 on the front-side only of the wafer (single-wafer). For instance, an oxide thickness of approximately 1000Å can be achieved using LPCVD or PECVD.
2) Deposit approximately 0.5 -1µ bosphosilicate glass (BSG) 16 which is 4-10% boron on the wafer backside (single-wafer). Alternatively the BSG can be deposited, using a furnace, on both sides of the wafer. The BSG serves to prevent substrate dopant out diffusion.
3) Deposit approximately 1300Å of silicon nitride 10 by a method of LPCVD on both sides of the wafer.
4) Coat the wafer backside with photoresist 12.
5) Etch the front nitride layer. This can be accomplished by well known plasma etch methods.
6) Strip the front oxide layer 6 and then strip resist 12.
7) Pre clean the wafer for the furnace use followed by an anneal at for instance, 1000-1100°C, to form a blanket p+ layer on the wafer backside.
8) The wafer is now ready for integrated RTP.

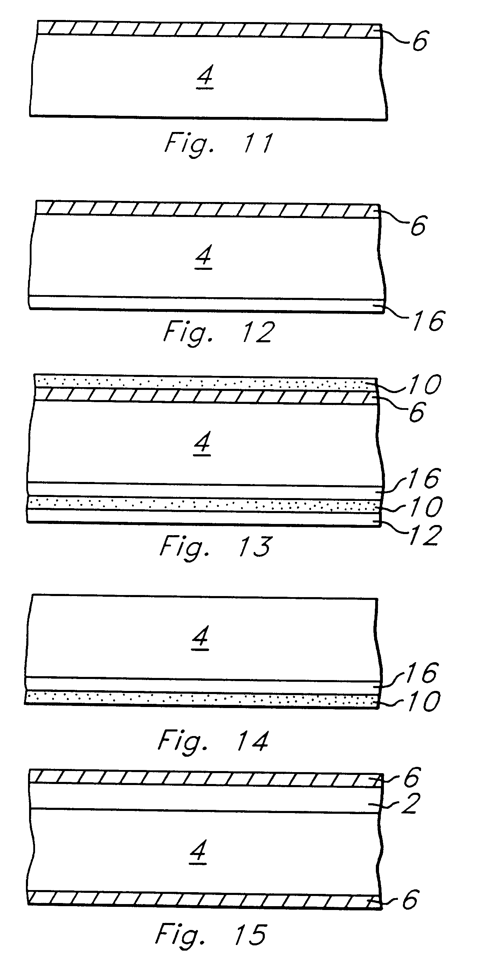

An alternative method for conditioning the backside of an epitaxial layer is presented below with reference to the cross-sectional drawings of the structure resulting from processing steps ilustrated in figures 15-18.
1) Deposit, on the wafer backside and front-side, an approximately 1000Å thick layer of oxide 6 by LPCVD or alternatively form the oxide by thermal oxidation.
2) Deposit an approximately 1000-1300Å thick layer of silicon nitride 10 on the front-side and backside of the wafer by a method of LPCVD.
3) Coat the wafer backside with photoresist 12.
4) Etch nitride 10 from the wafer front-side. For instance, well known plasma etch techniques can be used.
5) Strip the front oxide 6.
6) Strip resist 12.
7) Preclean the wafer for use in a wafer furnace.
8) The wafer is now ready for integrated RTP.

In order to achieve excellent RTP uniformity and wafer-to-wafer repeatabilty, the uniformity of the backside oxide and nitride layer thickness should be as high as possible. This will ensure uniform and repeatable emissivity conditions from the wafer so as to achieve accurate wafer temperature measurements.

### ADVANTAGES OF THE INVENTION

The invention provides advantages which include the following:
1. Uniform backside emissivity are provided.
2. Constant backside layers through integrated flow are provide thus yielding a non-varying emissivity.
3. A diffusion barrier against outdiffussion of the substrate dopant is provided.
4. Oxidation resistance of the backside nitride (e.g. during field oxidation) prevents growth of oxide on the backside during wafer processing.
5. The nitride/oxide stack is a much better diffusion barrier than just oxide against dopant diffusion.
6. The backside nitride remains intact throughout the integrated flow since little nitride etch occurs during the oxide etch steps.

Although the invention has been described in detail herein with reference to its preferred embodiment and certain described alternatives, it is to understood that this description is by way of example only and it is not to be construed in a limiting sense. It is to be further understood that numerous changes in the details of the embodiments of the invention, and additional embodiments of the invention, will be apparent to, and may be made by persons of ordinary skill in the art having reference to this description. It is contemplated that all such changes and additional embodiments are within the true scope and spirit of the invention as claimed below.

## Claims

1. A method of semiconductor wafer backside preparation for rapid thermal processing comprising:
depositing a protective oxide layer on the front-side of the wafer;
depositing a seal oxide layer on the backside of the wafer;
depositing a nitride layer on the front-side and backside of the wafer;
coating the backside of the wafer with a photoresist layer;
stripping the nitride layer from the front-side of the wafer;
stripping the photoresist layer from the wafer; and
stripping the oxide layer from the front-side of the wafer.

2. The method of claim 1 wherein said wafer is an epitaxial wafer.

3. A method of semiconductor wafer backside preparation for rapid thermal processing comprising:
placing a layer of silicon oxide on both front-side and backside of said wafer;
depositing a nitride layer on the backside and front-side of said wafer;
implanting atoms of a higher dopant concentration than that of said wafer, a predetermined distance into said wafer;
coating said wafer backside with photoresist;
removing said front-side nitride layer;
stripping said front-side oxide from said wafer;
stripping said photoresist from said wafer; and
annealing said wafer.

4. A method of semiconductor bulk wafer backside preparation for rapid thermal processing comprising:
forming an oxide on the front-side of said wafer;
depositing bosphosilicate glass on the backside of said wafer;
depositing nitride on said wafer backside and front-side;
coating said wafer backside with photoresist;
etching said nitride from said front-side;
stripping said oxide on said wafer front-side; and
stripping said photoresist from said wafer backside.

5. A method of semiconductor epitaxial wafer backside preparation for rapid thermal processing comprising:
depositing a layer of oxide on said wafer front-side and backside;
depositing nitride on said wafer backside and front-side;
coating said backside with photoresist;
etching away said front-side nitride from said wafer;
etching away said front-side oxide from said wafer; and
stripping and photoresist from said wafer backside.
